(19) **Europäisches Patentamt**

**European Patent Office**

**Office européen des brevets**

(11) **EP 1 037 285 A1**

(12) **EUROPEAN PATENT APPLICATION**

(43) Date of publication:
20.09.2000 Bulletin 2000/38

(51) Int. Cl.⁷: **H01L 29/739**, H01L 29/78, H01L 29/10

(21) Application number: **00105310.7**

(22) Date of filing: **15.03.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **15.03.1999 JP 6806999**

(71) Applicant:
**KABUSHIKI KAISHA TOSHIBA
Kawasaki-shi, Kanagawa-ken 210-8572 (JP)**

(72) Inventors:
• **Muraoka, Hiroki,
Toshiba Kabushiki Kaisha
Minato-ku Tokyo 105-8001 (JP)**
• **Tsunoda, Tetsujiro,
Toshiba Kabushiki Kaisha
Minato-ku Tokyo 105-8001 (JP)**
• **Kuwahara, Masashi,
Toshiba Kabushiki Kaisha
Minato-ku Tokyo 105-8001 (JP)**

(74) Representative: **HOFFMANN - EITLE
Patent- und Rechtsanwälte
Arabellastrasse 4
81925 München (DE)**

(54) **Semiconductor device having a trench gate structure**

(57) A U-IGBT of the present invention has a trench gate structure comprising gate electrodes (15) embedded in trenches (10) formed on a major surface of a semiconductor substrate (11), using sidewalls of each of the trenches as a channel region. The U-IGBT has a source region (13) comprising first sections (13A) and second sections (13B). The first sections (13A) are formed in a first direction parallel to the longitudinal direction of the trench gate electrodes (15). The second sections (13B) are formed with a predetermined interval in a second direction perpendicular to the longitudinal direction of the trench gate electrodes (15) and connect neighboring first sections (13A) that are sandwiched by neighboring trench gate electrodes (15). The U-IGBT has a surface emitter electrode (17) formed so as to contact both the second sections (13B) of the source region (13) and a base region (12) adjoining thereto. The width of a second section (13B) in the source region (13) is two thirds or less of a cell pitch (P). The sum of the width of a second section (13B) in the source region (13) and the width of a base region (12) adjoining to the above second section (13B) is three times or less as large as the cell pitch (P).

FIG. 4

EP 1 037 285 A1

**Description**

The present invention relates to a semiconductor device having a trench gate structure wherein a gate electrode is embedded in a trench formed on a major surface of a semiconductor substrate and wherein sidewalls of a trench are used as a channel region and, more specifically, to a dimensional relation between a source pattern or base pattern, such as a power MOSFET (metal oxide semiconductor field effect transistor) and a power IGBT (insulated gate bipolar transistor), and an interval between neighboring trenches (cell pitch).

Generally, a power MOSFET and a power IGBT are used as a switching device for high voltage and large current. As an example of a power MOSFET for use as a switching device, there is known a structure having a plurality of trench gate MOSFET wherein a gate electrode is embedded in a trench formed and wherein sidewalls of a trench are used as a channel region, thereby not only improving the performance (switching characteristics, ON-state voltage, latch-up resistance, etc.) but also making feasible a fine structure (hereafter called "U-MOSFET"). Such a U-MOSFET is disclosed for example in A. Takano et al."30V Ultra-low on-resistance P-channel UMOSFETs PCIM '98. As an example of a power IGBT, there is known a structure having a plurality of trench gate IGBT (hereafter called "U-IGBT"). Such a U-IGBT is disclosed for example in U.S. Patent No. 5,821,580, N. Kuwahara "MOS DEVICE HAVING A TRENCH GATE STRUCTURE."

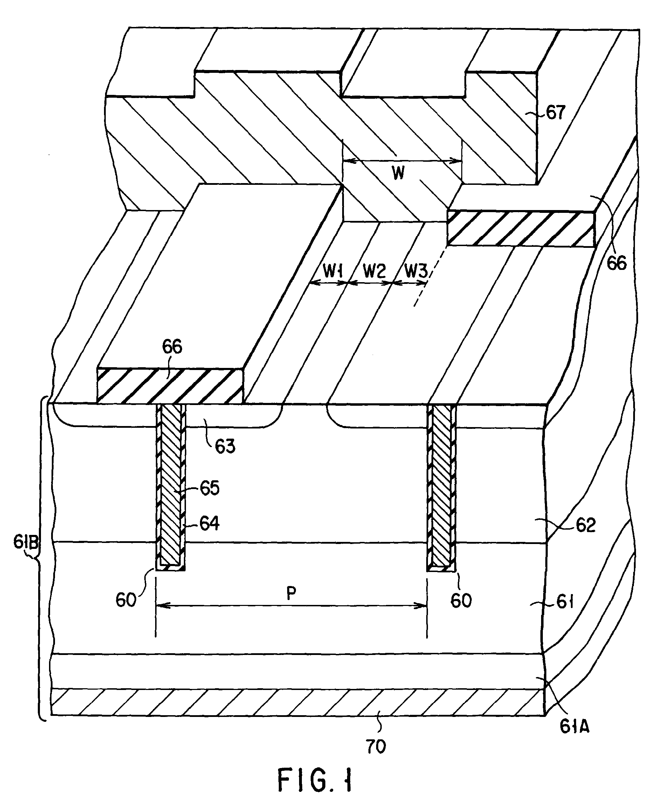

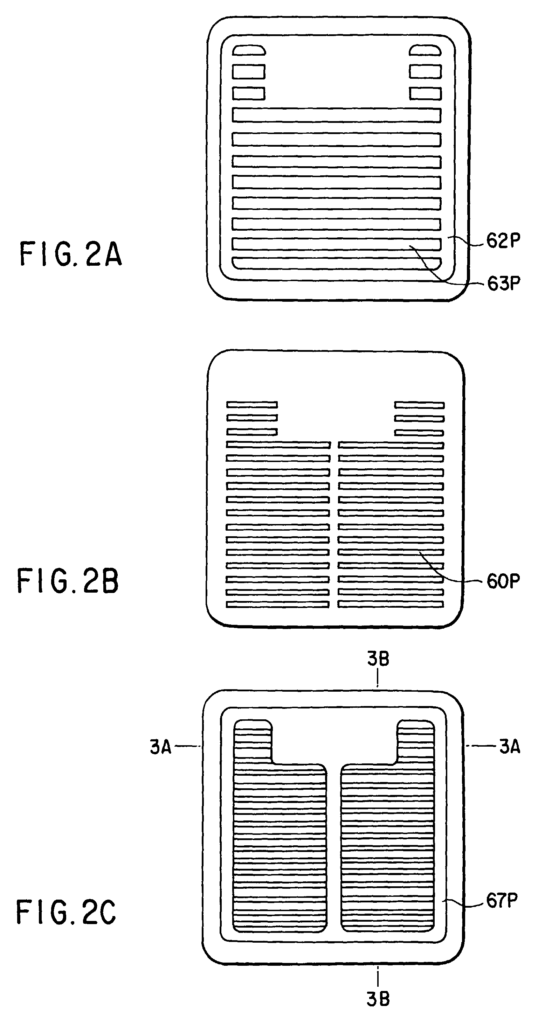

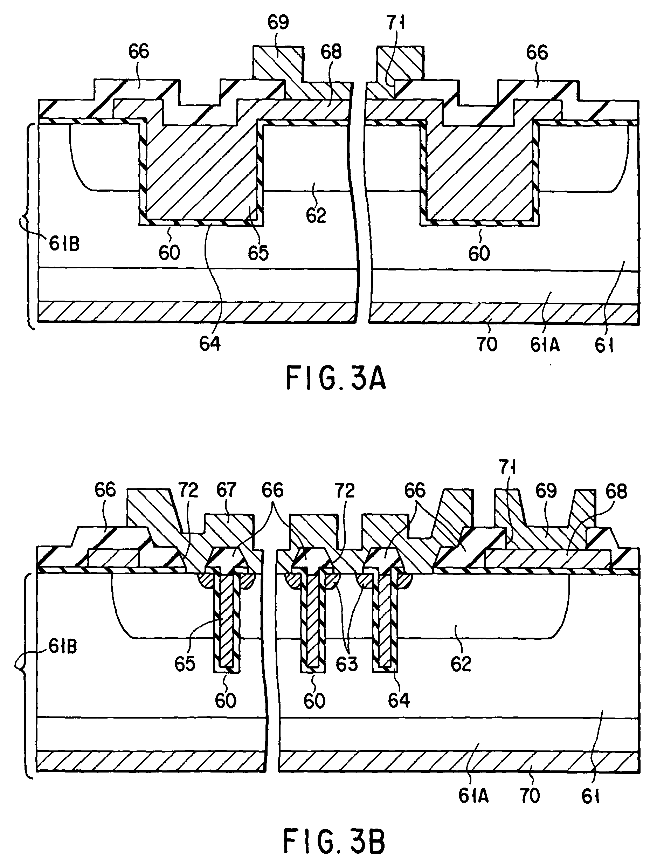

FIG. 1 is a partial perspective view illustrating a cross-section of a U-IGBT. FIGS. 2A through 2C are views illustrating examples of pattern in the U-IGBT shown in FIG. 1. FIG. 2A shows the patterns of a base and a source, FIG. 2B shows the pattern of a trench, and FIG. 2C shows the pattern of a trench gate lead-out. FIGS. 3A and 3B are a cross-sectional view of lines 3A-3A and 3B-3B, respectively, in the pattern shown in FIG. 2C.

As shown in the above figures, an n-type drift region 61, acting as a collector region, is formed in a major surface region of the p-type semiconductor substrate (silicon substrate) 61A. A p-type base region 62 is formed in a surface of the collector region 61, having a planar shape corresponding to a base pattern 62P in FIG. 2A. In the surface layer of the base region 62, n-type source regions (or emitter regions) 63 are formed with a planar shape similar to a source pattern 63P in FIG. 2A. A plurality of trenches 60 are formed with a planar shape similar to a trench pattern 60P shown in FIG. 2B. The trenches 60 go all the way across the source region 63 and the base region 62 to a depth reaching the collector region 61. A gate insulation film (SiO$_2$ film) 64 is formed on sidewalls and a bottom of each of the trenches 60. Each of the trenches 60 is filled with a gate electrode 65. The gate electrode 65 is laid on the gate insulating film 64 formed on a major surface of the semiconductor body 61B, having a wide pad 68 for contact with a gate electrode, as shown in FIGS. 3A and 3B. An interlayer insulating film 66 is formed on a resultant semiconductor structure. A large contact hole 71 for leading out the gate electrode 65 is formed on the pad 68 of the interlayer insulating film 66. A contact hole 72 for leading out a surface emitter electrode 67 is formed on the interlayer insulating film 66 on the outskirt of an opening of each of the trenches 60. The above contact holes 72 extend from a portion of a source region 63 to a portion of a source region 63 adjoining across the base region 62 to the above source region 63.

A surface emitter electrode 67 is formed on the interlayer insulating film 66 above the trenches 60. The surface emitter electrode 67 electrically connects the source regions 63 to the base region 62. The gate electrode 69 is formed on the interlayer insulating film 66 and within the contact hole 71 and is electrically connected to the pad 68. A collector electrode 70 is formed on the rear surface of the semiconductor substrate 61A.

A manufacturing process of the above construction of U-IGBT is explained below. A mask having a planar window corresponding to the base pattern 62P is formed on the collector region 61, which is formed in the major surface of the semiconductor substrate 61A. A major surface region of the semiconductor body 61B is doped through the above mask with p-type impurity ions. The impurities are thermally diffused to form a p-type base region 62 in a surface layer of the semiconductor body 61B. After forming a mask having a planar window corresponding to the base pattern 63P on the major surface of the above semiconductor body 61B, a major surface region of the semiconductor body 61B is doped with n-type impurity ions, which are then thermally diffused to form an n-type source region 63 in a surface layer of the base region 62.

Then, after forming a mask corresponding to the trench pattern 60P on the major surface of the above semiconductor body 61B, a plurality of trenches 60 are formed by an anisotropic etching technology, such as RIE, in the above source region 63. The trenches 60 are formed so as to go through the source region 63 and the base region 62 and to reach the collector region 61. Afterwards, both internal walls of the trenches 60 and the major surface of the semiconductor body 61B are thermally oxidized to form a gate insulating film (SiO$_2$ film) 64.

Then, a method of CVD (chemical vapor deposition) is used to fill the trenches 60 with phosphorus (P)-doped polysilicon and at the same time to deposit P-doped polysilicon on the whole surface of the gate insulating film 64.

Thereafter, the above polysilicon is patterned to form a wide pad 68 as a gate electrode contact for leading out a gate electrode 65. The top face of polysilicon in the vicinity of the trenches 60 is etched back to the major surface of the semiconductor body 61B to be flattened. Polysilicon embedded in each of the trenches 60 becomes a gate electrode 65. The above patterning causes the above polysilicon to be a planar shape like a trench gate lead-out pattern 67P shown in FIG. 2C.

Then, CVD is used to deposit an interlayer insulating film 66 on the resultant semiconductor structure. A mask is formed on the interlayer insulating film 66 and is etched to make a large contact hole 71 for leading out a gate electrode through the pad 68 as a gate electrode contact and to make a contact hole 72 for leading out a surface emitter electrode through the interlayer insulating film 66 on the outskirt of an opening of each of the trenches 60 and through the gate insulating film 64 lying on a surface of the semiconductor body 61B under the above opening.

Then, a metal (for example, aluminum) layer is formed on the interlayer insulating film 66 and in the contact holes 71 and 72 by a method such as sputtering. This metal layer is patterned to form a surface emitter electrode 67 and a gate electrode 69. Similarly, a metal layer is formed on a rear surface of the semiconductor body 61A by a method such as sputtering and a collector electrode 70 is formed.

A U-IGBT having the above-mentioned structure has a relatively large interval between neighboring trench gates (or cell pitch) P, and an opening width W of a contact is somewhat larger than accuracy of processing. Therefore, a source region 63 and the base region 62 are short-circuited everywhere in a longitudinal direction (first direction) of the trenches 60 by the surface emitter electrode 67.

To improve switching characteristics, particularly, to lower ON-state voltage, of a U-IGBT, it is effective to reduce a voltage drop in a channel by having a longer channel and a smaller current per cell. Therefore, it is desirable to reduce the cell pitch P and to reduce the opening width W of a contact 72. In short-circuiting a source region 63 and a base region 62 by a surface emitter electrode 67, optimum conditions considering latch-up resistance exist for an overlap distance W1 between a source region 63 and the surface emitter electrode 67, a distance W2 of the base region 62, and an overlap distance W3 between neighboring source regions 63 and the surface emitter electrode 67. Therefore, reduction of the opening width W is limited. If the opening were decreased, the contact resistance would increase to lower the latch-up resistance.

An object of the present invention is to provide a semiconductor device allowing latch-up resistance to be improved even when an interval between neighboring cell transistors (cell pitch) is reduced.

Another object of the present invention is to provide a semiconductor device restraining a voltage drop caused in a channel region to allow ON-state voltage to lower even when a cell pitch is reduced.

Yet another object of the present invention is to provide a semiconductor device securing sufficient latch-up resistance and to decrease ON-state voltage even when a cell pitch is reduced.

In order to attain the above objects, there is provided a semiconductor device comprising a first semiconductor region of a first conductivity type, a second semiconductor region of a second conductivity type formed in a surface layer of the first semiconductor region, a third semiconductor region of the first conductivity type formed in a surface layer of the second semiconductor region, a plurality of trenches each with a longitudinal direction lying in a first direction formed all the way through the third semiconductor region and the second semiconductor region to a depth reaching the first semiconductor region, a plurality of gate insulating films each formed on internal walls of each of the trenches and on the second semiconductor region and third semiconductor region, a plurality of trench gate electrodes each embedded in each of the trenches, an interlayer insulating film formed on a resultant semiconductor structure, a first electrode formed on the interlayer insulating film to contact both a part of the second semiconductor region and the third semiconductor region through a contact hole opened in the interlayer insulating film and the gate insulating film, and a second electrode formed on a backside of the first semiconductor region, wherein the third semiconductor region comprises a plurality of first sections formed along the first direction and a plurality of second sections formed with a predetermined interval in a second direction perpendicular to the longitudinal direction of the trenches and connected with the first sections adjacent to the second sections, the first electrode is contacted with the second sections in the third semiconductor region and simultaneously with the second semiconductor region adjacent to the second sections, and a width of the second sections in the third semiconductor region is two thirds or less of a cell pitch.

In order to attain the above objects, there is also provided a semiconductor device comprising a first semiconductor region of a first conductivity type, a second semiconductor region of a second conductivity type formed in a surface layer of the first semiconductor region, a third semiconductor region of the first conductivity type formed in a surface layer of the second semiconductor region, a plurality of trenches each with a longitudinal direction lying in a first direction formed all the way through the third semiconductor region and the second semiconductor region to a depth reaching the first semiconductor region, a plurality of gate insulating films each formed on internal walls of each of the trenches and on the second semiconductor region and third semiconductor region, a plurality of trench gate electrodes each embedded in each of the trenches, an interlayer insulating film formed on a resultant semiconductor structure, a first electrode formed on the interlayer insulating film to contact both a part of the second semiconductor region and the third semiconductor region through a contact hole opened in the interlayer insulating film and the gate insulating film, and a second electrode formed on a backside of the first semiconductor region, wherein the third semiconductor region comprises first sections formed along the first direction and a plurality of second sections formed with a predetermined interval in a second direction perpendicular to the longitudinal direction of the trenches and connected with the first sections adjacent to the second sections, the first electrode is contacted with the second sections in the third semiconductor region and simultaneously with the second semiconductor region adjacent to the second sections, and a sum of a width of the second sections in the second semiconductor region and a width of that portion of the second semiconductor region adjoining to the second sections is 3 times or less as large as a cell pitch.

In order to attain the above objects, there is further provided a semiconductor device comprising a first semiconductor region of a first conductivity type, a second semiconductor region of a second conductivity type formed in a surface layer of the first semiconductor region, a third semiconductor region of the first conductivity type formed in a surface layer of the second semiconductor region, a plurality of trenches each with a longitudinal direction lying in a first direction formed all the way through the third semiconductor region and the second semiconductor region to a depth reaching the first semiconductor region, a plurality of gate insulating films each formed on internal walls of each of the trenches and on the second semiconductor region and third semiconductor region, a plurality of trench gate electrodes each embedded in each of the trenches, an interlayer insulating film formed on a resultant semiconductor structure, a first electrode formed on the interlayer insulating film to contact both a part of the second semiconductor region and the third semiconductor region through a contact hole opened in the interlayer insulating film and the gate insulating film, and a second electrode formed on a backside of the first semiconductor region, wherein the third semiconductor region comprises first sections formed along the first direction and a plurality of second sections formed with a predetermined interval in a second direction perpendicular to the longitudinal direction of the trenches and connected with the first sections adjacent to the second sections, the first electrode is contacted with the second sections in the third semiconductor region and simultaneously with the third semiconductor region adjacent to the second sections, a width of the second sections in the third semiconductor region is two thirds or less of a cell pitch, and a sum of a width of the second sections in the second semiconductor region and a width of that portion of the second semiconductor region adjoining to the second sections is three times or less as large as the cell pitch.

According to the above structures of the present invention, a dimensional relation in pattern between the third semiconductor region or the second semiconductor region and the interval between neighboring trench gates (cell pitch) is optimized, allowing latch-up resistance to be improved even when the cell pitch is reduced, making it possible to control a voltage drop in a channel region so as to lower ON-state voltage even when the cell pitch is reduced, and making it possible to secure latch-up resistance and simultaneously to lower ON-state voltage.

This summary of the invention does not necessarily describe all necessary features so that the invention may also be a sub-combination of these described features.

The invention can be more fully understood from the following detailed description when taken in conjunction with the accompanying drawings, in which:

FIG. 1 is a partial perspective view illustrating a cross-section of a U-IGBT, intended to explain prior art;

FIG. 2A is a plan view illustrating an example of base pattern and source pattern in the U-IGBT shown in FIG. 1;

FIG. 2B is a plan view illustrating an example of trench pattern in the U-IGBT shown in FIG. 1;

FIG. 2C is a plan view illustrating an example of trench gate lead-out pattern in the U-IGBT shown in FIG. 1;

FIG. 3A is a cross-sectional view illustrating a structure along line 3A-3A in the pattern shown in FIG. 2C;

FIG. 3B is a cross-sectional view illustrating a structure along line 3B-3B in the pattern shown in FIG. 2C;

FIG. 4 is a partial perspective view illustrating a cross-section of a U-IGBT according to a first embodiment of the present invention;

FIG. 5A is a plan view illustrating an example of base pattern and source pattern in the U-IGBT shown in FIG. 4;

FIG. 5B is a plan view illustrating an example of trench pattern in the U-IGBT shown in FIG. 4;

FIG. 5C is a plan view illustrating an example of trench gate lead-out pattern in the U-IGBT shown in FIG. 4;

FIG. 5D is a plan view showing an enlargement of the region encircled with a broken line in FIG. 5B;

FIG. 6 is a graph showing latch-up resistance characteristics of a U-IGBT shown in FIGS. 4 and 5A through 5D;

FIG. 7 is a graph showing ON-state voltage characteristics of the U-IGBT shown in FIGS. 4 and 5A through 5D;

FIG. 8 is a plan view illustrating an example of another source pattern in a modification of a semiconductor device according to the first embodiment of the present invention;

FIG. 9 is a partial perspective view illustrating a cross-section of a U-MOSFET according to a second embodiment of the present invention; and

FIG. 10 is a partial perspective view illustrating a cross-section of an IEGT according to a third embodiment of the present invention.

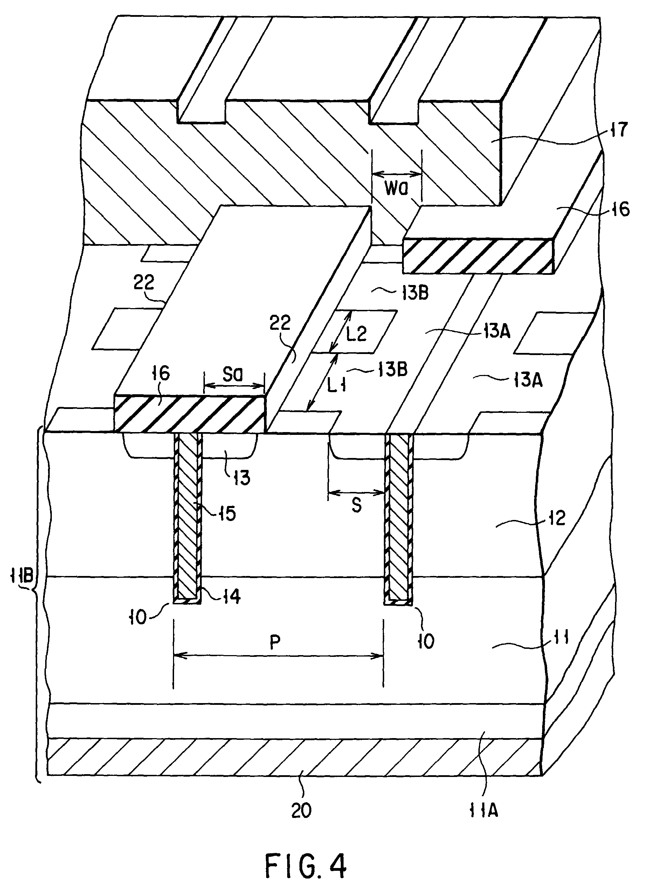

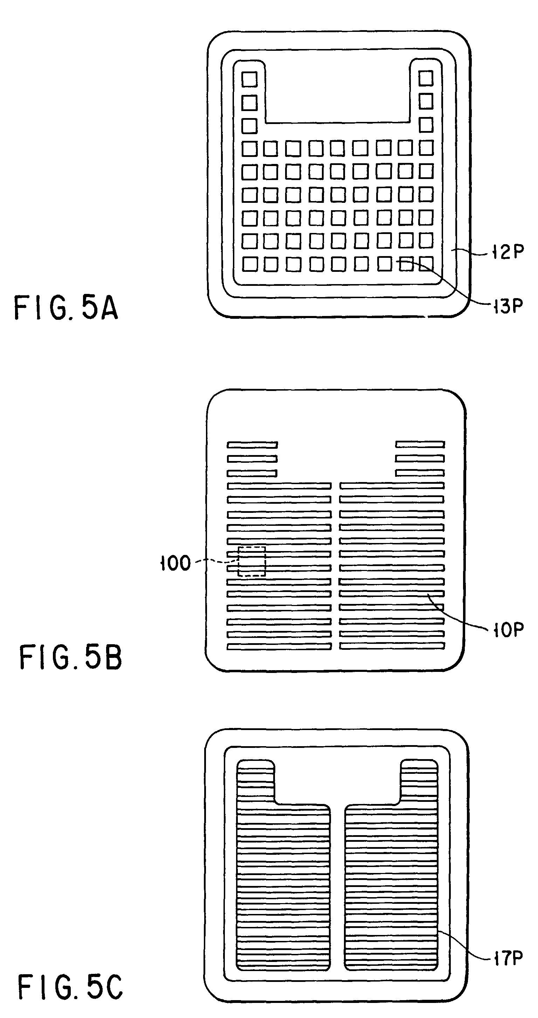

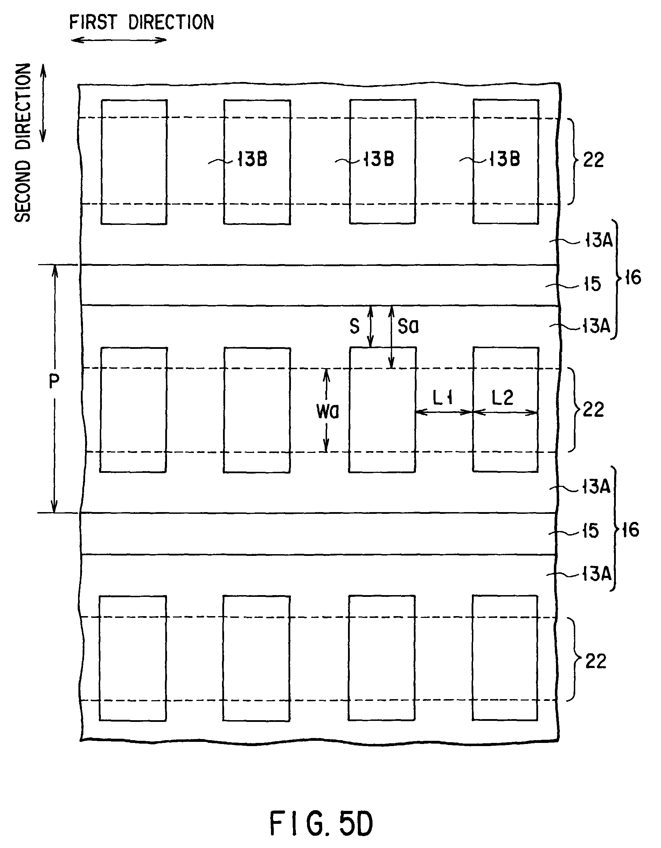

FIG. 4 is a partial perspective view illustrating a cross-section of a U-IGBT according to a first embodiment of the present invention. FIGS. 5A through 5C are plan views illustrating a base pattern and a source pattern, trench pattern, and trench gate lead-out pattern, respectively, of a U-IGBT shown in FIG. 4. FIG. 5D is a plan view showing an enlargement of the region encircled with a broken line 100 in FIG. 5B.

Referring to FIG. 4, an n-type drift region 11, acting as a collector region of a bipolar transistor, is formed in a major surface region of the p-type semiconductor substrate (silicon substrate) 11A. A p-type base region 12 is formed in a major surface region of the collector region 11, corresponding to a base pattern 12P shown in FIG. 5A. A plurality of $n^+$-type source regions (or emitter regions) 13 having a planar mesh (square lattice) pattern, like a source pattern 13P shown in FIG. 5A, are formed on a surface layer of the base region 12. A plurality of trenches 10 having a planar shape corresponding to a trench pattern 10P shown in FIG. 5B are formed, passing through the source regions 13 and base region 12 and reaching the collector region 11. A gate insulating film ($SiO_2$ film) 14 is formed on sidewalls and bottom, respectively, of each of the trenches 10. A gate electrode 15 is embedded in each of the trenches 10. The gate electrodes 15 are extended to a pad for use as a gate electrode lead-out (not shown), in a similar way to prior art. The resultant semiconductor structure has an interlayer insulating film 16 formed thereon. A large contact hole for the gate electrode lead-out is formed on the pad of the interlayer insulating film 16. The interlayer insulating film 16 has contact holes 22 for a surface emitter electrode lead-out formed on the outskirt of an opening of each of the trenches 10. Each of the contact holes 22 extends from a part of the source region 13 to that part of the source region 13 adjoining across the base region 12 to the former part.

A surface emitter electrode 17 is formed over the interlayer insulating film 16 above the trenches 10. The surface emitter electrode 17 is composed of metal layers, such as aluminum layers, short-circuiting between the source region 13 and the base region 12 in the contact hole 22. A collector electrode 20 composed of layers of metal, such as aluminum, is formed on the rear surface of the semiconductor substrate 11A.

FIG. 5D is a plan view showing an enlargement of the region encircled with a broken line 100 in FIG. 5B. The source region 13 comprises first sections 13A and second sections 13B. The first sections 13A lie in a first direction parallel to a longitudinal direction of the trench gate electrodes 15. The second sections 13B lie in a second direction perpendicular to the longitudinal direction of the trench gate electrodes 15, separated with a predetermined interval and connecting the first sections 13A in a region sandwiched by neighboring trench gate electrodes 15. The surface emitter electrode 17 is contacted with the second sections 13B of the source region 13 and with the base region 12 adjacent to the second sections 13B.

A width L1 of each of the second sections 13B of a source region 13 (size in the first direction) is equal to or less than two thirds of an interval P (cell pitch) between neighboring trench gate electrodes 15. The sum of the width L1 and a width L2 of the base region sandwiched between neighboring second sections 13B, is set equal to or less than three times the cell pitch P, i.e., $L1 + L2 \leq 3P$. Accordingly, even when the cell pitch P is reduced to lower a contact opening width Wa, a latch-up resistance can be secured and ON-state voltage can be lower.

A width S of each of the first sections 13A of the source region 13, is set larger than a maximum deviation from a perfect mating between a pattern of the trenches 10 and a pattern of the source region 13, and is set smaller than a distance Sa on the bottom of an interlayer insulating film 16 from a trench gate electrode 15 to the surface emitter electrode 17. Thus, the width S of the first sections 13A of the source region 13 serves to prevent vanishment of the first sections 13A of the source region 13 and to secure contact of the base region 12 with the surface emitter electrode 17 even when a maximum deviation from a perfect mating between a pattern of the trenches 10 and a pattern of the source regions 13 exists.

The interlayer insulating film 16 completely cover the first sections 13A with a larger width, causing the surface emitter electrode 17 to be in contact with the second sections 13B and simultaneously with the base region 12 adjacent thereto. This covering makes it possible to have a distance from the trench gate electrode 15 to a contact of the surface emitter electrode 17, and the reliability can be enhanced.

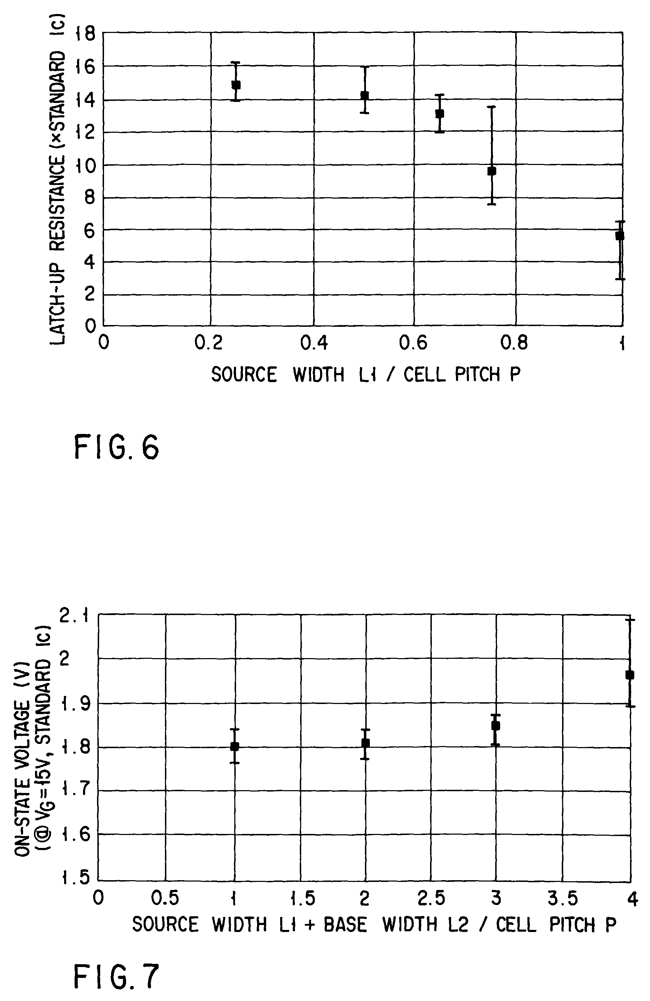

FIG. 6 is a graph showing latch-up resistance characteristics of a U-IGBT shown in FIGS. 4 and 5A through 5D. These characteristics are based on results of an examined relation between the latch-up resistance and ratios of the width L1 of the second sections 13B and the cell pitch P in a test using 10 samples.

In the above test, it was assumed that the value of Ic required for a product be 6 times the rated collector current Ic if no instantaneous protection circuit is used, and be $3.5 \times Ic$ if an instantaneous protection circuit is used. It was also assumed that a minimum required value as a chip characteristic be $10 \times Ic$ in consideration of a short-circuit rush. The width S of the sections 13A of the source region 13 was set at 2.6 $\mu m$ or shorter in order to secure a value of $10 \times Ic$ when the cell pitch is 4 $\mu m$.

It is found from FIG. 6 that as the ratio L1/P goes up, the latch-up resistance falls very steeply. This is because as the width S of the sections 13A of the source region 13 increases, a latent resistance Rs in the base region below the source region 13, becomes larger, thereby making a parasitic NPN transistor operate more easily due to a rise in a base potential (Rs × hole current) of the parasitic NPN transistor when a certain value of hole current flows through the base region 12 in an OFF-state of the U-IGBT.

It is consequently clear that if the width L1 of the sections 13B of the source region 13 is set to be two thirds or less of the cell pitch P, the latch-up resistance can be improved.

In an ON-state of the U-IGBT, electrons are injected at the surface emitter electrode 17, flowing into the channel region from the sections 13B of the source region 13. In this process, if the width L1 of the sections 13B of the source region 13 becomes much smaller than the base region width L2, a contact area between the surface emitter electrode 17 and a source region 13 becomes smaller, resulting in an increase of a contact resistance between an emitter electrode (A1) and a source region 13 and hence in a rise of ON-state voltage.

FIG. 7 is a graph showing ON-state voltage characteristics of the U-IGBT shown in FIGS. 4 and 5A through 5D. These characteristics are based on results of an examined relation between a ratio of a sum of the width L1 of the sections 13B of a source region 13 and the width L2 of the base region 12 adjacent thereto to the cell pitch P, (L1 + L2)/P , and ON-state voltage of the U-IGBT in a test using 10 samples. The width L1 of the sections 13B of a source region 13 is set between 1 and 4 μm. The width L2 of the base region 12 is set between 2 and 14 μm.

It is found from FIG. 7 that near a point where the sum (L1 + L2) exceeds 3 times the cell pitch P, ON-state voltage starts rising. Although this starting point depends on a current density, impurity concentration in the source region 13, cell pitch P, etc., it is clearly understood that if the sum (L1 + L2) is set at 3 times or less the cell pitch P, ON-state voltage can be decreased.

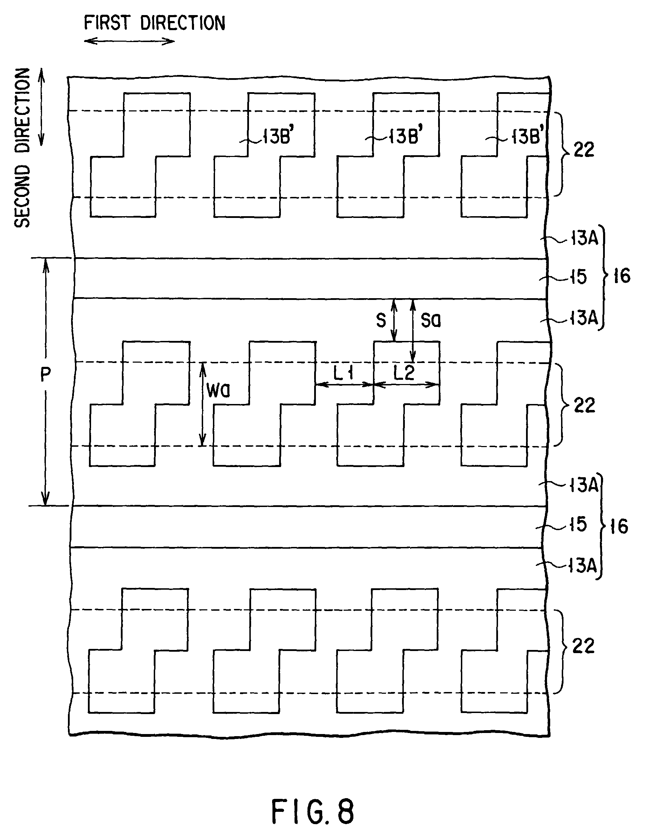

FIG. 8 is a plan view intended to explain an example of modification of a semiconductor device according to the first embodiment of the present invention, illustrating an example of another source pattern. FIG. 8 corresponds to FIG. 5D. As shown in FIG. 8, a source region 13 has a planar offset mesh (hound's-tooth check) pattern. In other words, a source region 13 has first sections 13A and second sections 13B'. The first sections 13A are formed so as to lie in a first direction parallel to a longitudinal direction of the above trench gate electrodes 15. The second sections 13B' are formed so as to wind in a second direction perpendicular to the longitudinal direction of the trench gate electrodes 15, separated with a predetermined interval and connecting the first sections 13A in a region sandwiched by neighboring trench gate electrodes 15.

With a pattern shown in FIG. 8, it is possible to reduce ON-state voltage while securing latch-up resistance even when both a cell pitch P and a contact opening width Wa are reduced, by setting a width L1 of each of the second sections 13B' of a source region 13, at two thirds or less of the cell pitch P as well as by setting the sum of the width L1 and a width L2 of the base region 12 sandwiched between neighboring second sections 13B', at three times or less the cell pitch P. Like the pattern shown in FIG. 5D, if a width S of each of the first sections 13A, is set at a minimum processable size for a U-IGBT, is set larger than a maximum deviation from a perfect mating between a pattern of trenches 10 and a pattern of the source regions 13, and is set smaller than a distance Sa on the bottom of an interlayer insulating film 16 from the trench gate electrode 15 to a surface emitter electrode 17, then it is possible to prevent vanishment of the first sections 13A of a source region 13, to secure contact of the base region 12 with the surface emitter electrode 17, and to secure withstand voltage.

A structure for leading out the trench gate electrodes 15 are not limited to the structure for forming a wide pad 68 for contact with a gate electrode shown in FIGS. 3A and 3B. It is possible to employ various structures.

A semiconductor device according to the present invention is not limited to the U-IGBT described in the first embodiment, but is equally applicable to U-MOSFET and further to injection enhanced gate transistors (IEGT).

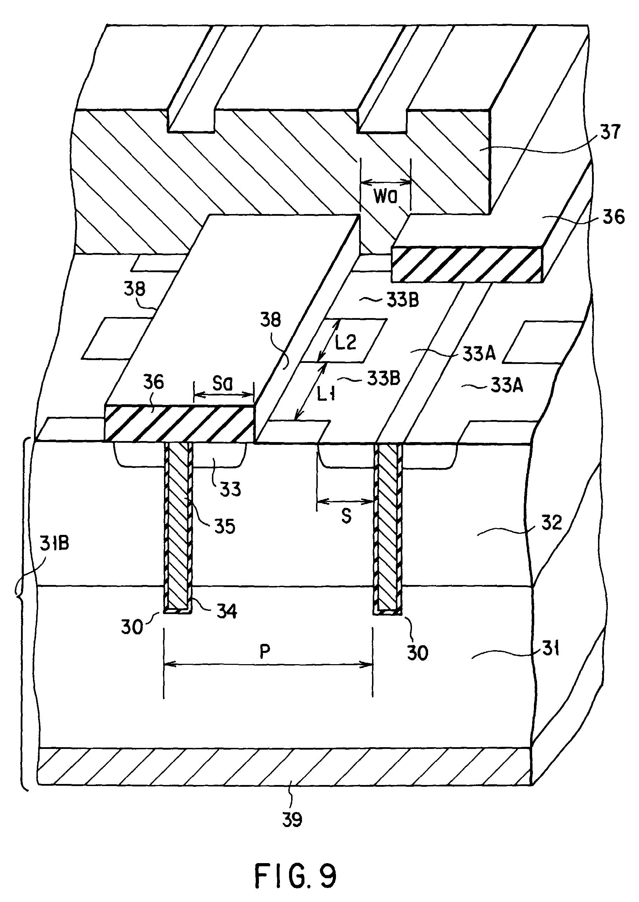

FIG. 9 is a partial perspective view illustrating a cross-section of a U-MOSFET according to a second embodiment of the present invention.

As shown in the FIG. 9, a p-type base region 32 is formed in a major surface region of the n-type semiconductor substrate (silicon substrate) 31 serving as a drain region of the MOS transistor, having a planar shape corresponding to a base pattern 12P in FIG. 5A. In the surface layer of the base region 32, a plurality of $n^+$-type source regions 33 are formed with a planar shape similar to a source pattern 13P in FIG. 5A. The source regions 33 comprise first sections 33A and second sections 33B. The first sections 33A lie in a first direction parallel to a longitudinal direction of the trench gate electrodes 35. The second sections 33B lie in a second direction perpendicular to the longitudinal direction of the trench gate electrodes 35, separated with a predetermined interval and connecting the first sections 33A in a region sandwiched by neighboring trench gate electrodes 35. The surface source electrode 37 is contacted with the second sections 33B of the source region 33 and with the base region 32 adjacent to the second sections 33B.

A width L1 of each of the second sections 33B of a source region 33 (size in the first direction) is equal to or less than two thirds of an interval P (cell pitch) between neighboring trench gate electrodes 35. The sum of the width L1 and a width L2 of the base region 32 sandwiched between neighboring second sections 33B, is set equal to or less than three times the cell pitch P, i.e., $L1 + L2 \leq 3P$.

A plurality of trenches 30 are formed with a planar shape similar to a trench pattern 10P shown in FIG. 5B. The trenches 30 go all the way across the source region 33 and the base region 32 to a depth reaching the semiconductor substrate 31. A gate insulation film (SiO$_2$ film) 34 is formed on sidewalls and a bottom of each of the trenches 30. Each of the trenches 30 is filled with a gate electrode 35. The gate electrode 35 is laid on the gate insulating film 34 formed on a major surface of the semiconductor body 31B. A contact hole 38 for leading out a surface source electrode 37 is formed on the interlayer insulating film 36 on the outskirt of an opening of each of the trenches 30. The above contact holes 38 extend from a portion of a source region 33 to a portion of a source region 33 adjoining across the base region 32 to the above source region 33.

A surface source electrode 37 is formed on the interlayer insulating film 36 above the trenches 30. The surface source electrode 37 electrically connects the source regions 33 to the base region 32. The gate electrode (not shown) is formed on the interlayer insulating film 36 and within the contact hole and is electrically connected to the pad. A drain electrode 39 is formed on the rear surface of the semiconductor substrate 31.

Accordingly, even when the cell pitch P is reduced to lower a contact opening width Wa, a latch-up resistance can be secured and ON-state voltage can be lower.

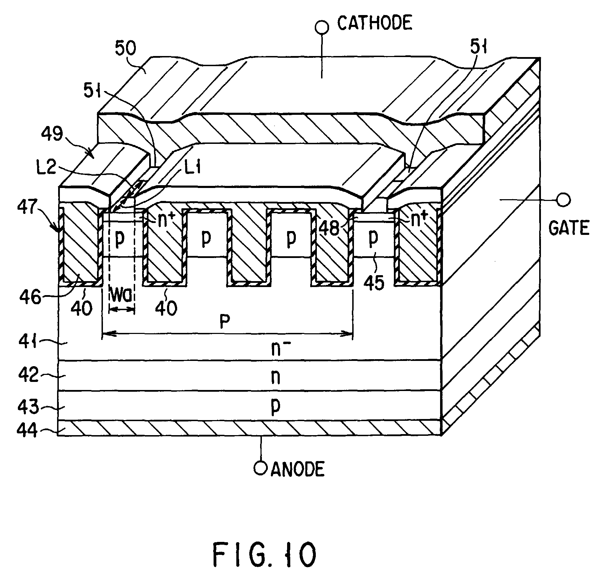

FIG. 10 is a partial perspective view intended to explain a semiconductor device according to a third embodiment of the present invention, illustrating an IEGT.

The IEGT is based on a technology for enhancing accumulation of carriers at a tip of a control electrode composed of a high-resistance layer by forming a special trench gate structure so as to decrease the number of contacts of a cathode electrode with a source region and with a base region. This technology makes it possible to achieve as small ON-state resistance as a thyristor and to provide as safe an operational region as a transistor.

As shown in FIG. 10, an n-type buffer layer 42 and a p-type emitter layer 43 are formed below an n⁻-type layer 41, while an anode electrode 44 is formed on a backside of the p-type emitter layer 43. A p-type base layer 45 is formed on a surface layer of the n⁻-type layer 41. Trenches 40 are formed from the top face of the p-type base layer 45 to a depth reaching the n⁻-type layer 41. A gate insulating film (for example, SiO$_2$ film) 47 is formed on inner walls of each of the trenches 40 and on a part of the p-type base layer 45. A trench gate electrode 46 is embedded in each of the trenches 40. An n⁺-type source region 48 is formed, for example, every three trench gates 46 on the surface layer. An interlayer insulating film (for example, CVD oxide film) 49 is formed on a resultant semiconductor structure. A cathode electrode 50 is formed on the interlayer insulating film 49, being in contact, through a contact hole formed in the interlayer insulating film 49, with a surface of each of the n⁺-type source regions 48 and with a surface of that surface portion of the p-type base layer 45 adjoining to the above n⁺-type source region 48.

A width L1 of each of the n⁺-type source regions 48, a width L2 of each section of the p-type base layer 45, and a cell pitch P (which is not an interval between neighboring trench gates but between neighboring n⁺-type source regions 48) are set in a similar way to the first embodiment earlier, causing an effect similar to that of U-IGBT to be attained.

For an IEGT having trench gates 46 formed with a fine interval on a surface on the cathode side as described above and having a cathode electrode 50 contacted with source regions 48 at a regular interval, trench gates 46 serve to prevent positive holes injected in the p-type emitter layer 43 from flowing out of the cathode electrode 50. On the other hand, electrons coming from the cathode electrode 50 are injected through a MOS channel. Thus, the number of injected electrons is much larger than the number of out-flowing positive holes, or in a high-injection state, causing ON-state resistance of a high-resistance base layer 45 to be as small as that of a thyristor.

As explained above, a semiconductor device according to the present invention makes it possible either to improve latch-up resistance or to lower ON-state voltage, or both, by optimizing a relation between a size of a mesh source pattern and an interval between cell transistors (cell pitch) even when the cell pitch is reduced.

## Claims

1. A semiconductor device, comprising a first semiconductor region (11, 31) of a first conductivity type; a second semiconductor region (12, 32) of a second conductivity type formed in a surface layer of said first semiconductor region (11, 31); a third semiconductor region (13, 33) of the first conductivity type formed in a surface layer of said second semiconductor region (12, 32); a plurality of trenches (10, 39) each with a longitudinal direction lying in a first direction formed all the way through the third semiconductor region (13, 33) and the second semiconductor region (12, 32) to a depth reaching said first semiconductor region (11, 31); a plurality of gate insulating films (14, 34) each formed on internal walls of each of said trenches (10, 39) and on said second semiconductor region (12, 32) and third semiconductor region (13, 33); a plurality of trench gate electrodes (15, 35) each embedded in each of said trenches (10, 39); an interlayer insulating film (16, 36) formed on a resultant semiconductor structure; a first electrode (17, 37) formed on said interlayer insulating film (16, 36) to contact both a part of said second semiconductor region (12, 32) and said third semiconductor region (13, 33) through a contact hole (22, 38) opened in said interlayer insulating film (16, 36) and said gate insulating film (14, 34); and a second electrode (20, 39) formed on a backside of said first semiconductor region (11, 31),

characterized in that said third semiconductor region (13, 33) comprises a plurality of first sections (13A, 33A) formed along the first direction and a plurality of second sections (13B, 33B) formed with a predetermined interval in a second direction perpendicular to the longitudinal direction of said trenches (10, 30), said second sections (13B, 33B) connecting neighboring first sections (13A, 33A),

said first electrode (17, 37) is contacted with said second sections (13B, 33B) in said third semiconductor region (13, 33) and simultaneously with said second semiconductor (12, 32) region adjacent to said second sections (13B, 33B), and

a width of said second sections (13B, 33B) in said third semiconductor region (13, 33) is two thirds or less of a cell pitch.

2. A semiconductor device according to claim 1, composed of metal oxide semiconductor field effect transistors, characterized in that said first semiconductor region (31) serves as a drain region, said second semiconductor region (32) serves as a base region, said third semiconductor region (33) serves as an source region, said first electrode (37) serves as a surface source electrode, and said second electrode (39) serves as a drain electrode.

3. A semiconductor device according to claim 1, characterized by further comprising a forth semiconductor region (11A) of the second conductivity type formed in the rear surface of said first semiconductor region (11), and the semiconductor device composed of insulated gate bipolar transistors, characterized in that said first semiconductor region (11) serves as a collector region, said second semiconductor region (12) serves as a base region, said third semiconductor region (13) serves as an emitter region, said first electrode (17) serves as a surface emitter electrode, and said second electrode (20) serves as a collector electrode.

4. A semiconductor device according to claim 1, characterized in that said second sections (13B, 33B) in said third semiconductor region (13, 33) have a width between 1 μm and 4 μm, and said second semiconductor region (12, 32) adjacent to said second sections (13B, 33B) has a width between 2 μm and 14 μm.

5. A semiconductor device, comprising a first semiconductor region (11, 31) of a first conductivity type; a second semiconductor region (12, 32) of a second conductivity type formed in a surface layer of said first semiconductor region (11, 31); a third semiconductor region (13, 33) of the first conductivity type formed in a surface layer of said second semiconductor region (12, 32); a plurality of trenches (10, 30) each with a longitudinal direction lying in a first direction formed all the way through the third semiconductor region (13, 33) and the second semiconductor region (12, 32) to a depth reaching said first semiconductor region (11, 31); a plurality of gate insulating films (14, 34) each formed on internal walls of each of said trenches (10, 30) and on said second semiconductor region (12, 32) and third semiconductor region (13, 33); a plurality of trench gate electrodes (15, 35) each embedded in each of said trenches (10, 30); an interlayer insulating film (16, 36) formed on a resultant semiconductor structure; a first electrode (17, 37) formed on said interlayer insulating film (16, 36) to contact both a part of said second semiconductor region (12, 32) and said third semiconductor region (13, 33) through a contact hole (22, 38) opened in said interlayer insulating film (16, 36) and said gate insulating film (14, 34); and a second electrode (20, 39) formed on a backside of said first semiconductor region (11, 31),

characterized in that said third semiconductor region (13, 33) comprises first sections (13A, 33A) formed along said first direction and a plurality of second sections (13B, 33B) formed with a predetermined interval in a second direction perpendicular to the longitudinal direction of said trenches (10, 30), said second sections (13B, 33B) connecting neighboring first sections (13A, 33A),

said first electrode (17, 37) is contacted with said second sections (13B, 33B) in said third semiconductor region (13, 33) and simultaneously with said second semiconductor region (12, 32) adjacent to said second sections (13B, 33B), and

a sum of a width of said second sections (13B, 33B) in said second semiconductor region (13, 33) and a width of that portion of said second semiconductor region (13, 33) adjoining to said second sections (13, 33) is 3 times or less as large as a cell pitch.

6. A semiconductor device according to claim 5, composed of metal oxide semiconductor field effect transistors, characterized in that said first semiconductor region (31) serves as a drain region, said second semiconductor region (32) serves as a base region, said third semiconductor region (33) serves as an source region, said first electrode (37) serves as a surface source electrode, and said second electrode (39) serves as a drain electrode.

7. A semiconductor device according to claim 5, characterized by further comprising a forth semiconductor region (11A) of the second conductivity type formed in the rear surface of said first semiconductor region (11), and the semiconductor device composed of insulated gate bipolar transistors, characterized in that said first semiconductor region (11) serves as a collector region, said second semiconductor region (12) serves as a base region, said third semiconductor region (13) serves as an emitter region, said first electrode (17) serves as a surface emitter electrode, and said second electrode (20) serves as a collector electrode.

8. A semiconductor device according to claim 5, characterized in that said second sections (13B, 33B) in said third semiconductor region (13, 33) have a width between 1 μm and 4 μm, and said second semiconductor region (12) adjacent to said second sections (13B, 33B) has a width between 2 μm and 14 μm.

9. A semiconductor device, comprising a first semiconductor region (11, 31) of a first conductivity type; a second semiconductor region (12, 32) of a second conductivity type formed in a surface layer of said first semiconductor region (11, 31); a third semiconductor region (13, 33) of the first conductivity type formed in a surface layer of said second semiconductor region (12, 32); a plurality of trenches (10, 39) each with a longitudinal direction lying in a first direction formed all the way through the third semiconductor region (13, 33) and the second semiconductor region (12, 32) to a depth reaching said first semiconductor region (11, 31); a plurality of gate insulating films (14, 34) each formed on internal walls of each of said trenches (10, 30) and on said second semiconductor region (12, 32) and third semiconductor region (13, 33); a plurality of trench gate electrodes (15, 35) each embedded in each of said trenches (10, 30); an interlayer insulating film (16, 36) formed on a resultant semiconductor structure; a first electrode (17, 37) formed on said interlayer insulating film (16, 36) to contact both a part of said second semiconductor region (12, 32) and said third semiconductor region (13, 33) through a contact hole (22, 38) opened in said interlayer insulating film (16, 36) and said gate insulating film (14, 34); and a second electrode (20, 39) formed on a backside of said first semiconductor region (11, 31), characterized in that said third semiconductor region (13, 33) comprises first sections (13A, 33A) formed along said first direction and a plurality of second sections (13B, 33B) formed with a predetermined interval in a second direction perpendicular to the longitudinal direction of said trenches (10, 30), said second sections (13B, 33B) connecting neighboring first sections (13A, 33A),

said first electrode (17, 37) is contacted with said second sections (13B, 33B) in said third semiconductor region (13, 33) and simultaneously with said second semiconductor region (12, 32) adjacent to said second sections (13B, 33B), a width of said second sections (13B, 33B) in said third semiconductor region (13, 33) is two thirds or less of a cell pitch, and a sum of a width of said second sections (13B, 33B) in said second semiconductor region (12, 32) and a width of that portion of said second semiconductor region (12, 32) adjoining to said second sections (13B, 33B) is three times or less as large as the cell pitch.

10. A semiconductor device according to claim 9, composed of metal oxide semiconductor field effect transistors, characterized in that said first semiconductor region (31) serves as a drain region, said second semiconductor region (32) serves as a base region, said third semiconductor region (33) serves as an source region, said first electrode (37) serves as a surface source electrode, and said second electrode (39) serves as a drain electrode.

11. A semiconductor device according to claim 9, characterized by further comprising a forth semiconductor region (11A) of the second conductivity type formed in the rear surface of said first semiconductor region (11), and the semiconductor device composed of insulated gate bipolar transistors, characterized in that said first semiconductor region (11) serves as a collector region, said second semiconductor region (12) serves as a base region, said third semiconductor region (13) serves as an emitter region, said first electrode (17) serves as a surface emitter electrode, and said second electrode (20) serves as a collector electrode.

12. A semiconductor device according to claim 9, characterized in that said second sections (13B, 33B) in said third semiconductor region (13, 33) have a width between 1 μm and 4 μm, and said second semiconductor region (12, 32) adjacent to said second sections (13B, 33B) has a width between 2 μm and 14 μm.

67

W

W1 W2 W3

66

66

63

65

64

62

61B

60

P

60

61

61A

70

FIG. 1

FIG.2A

62P

63P

FIG.2B

60P

FIG.2C

3B

3A

3A

67P

3B

FIG.3A

FIG.3B

FIG. 4

FIG. 5A

12P

13P

FIG. 5B

100

10P

FIG. 5C

17P

FIRST DIRECTION

SECOND DIRECTION

FIG. 5D

FIG. 6

FIG. 7

FIRST DIRECTION

SECOND DIRECTION

13B'  13B'  13B'  } 22

13A
15  } 16
13A

S  Sa

L1  L2

Wa

} 22

13A
15  } 16
13A

} 22

FIG. 8

FIG.9

FIG. 10

# EP 1 037 285 A1

**European Patent Office**

## EUROPEAN SEARCH REPORT

**Application Number**

EP 00 10 5310

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | HARADA M ET AL: "600V TRENCH IGBT IN COMPARISON WITH PLANAR IGBT AN EVALUATION OF THE LIMIT OF IGBT PERFORMANCE" PROCEEDINGS OF THE INTERNATIONAL SYMPOSIUM ON POWER SEMICONDUCTOR DEVICES (ISPSD),US,NEW YORK, IEEE, vol. SYMP. 6, 1994, pages 411-416, XP000505846 ISBN: 0-7803-1495-6 * page 414, column 1; figures 2,9A,9B; table 1 * | 1-12 | H01L29/739 H01L29/78 H01L29/10 |
| A | EP 0 668 616 A (MITSUBISHI ELECTRIC CORP) 23 August 1995 (1995-08-23) * page 7, line 15 - line 44; figure 11 * * page 19, line 46 - page 22, line 14 * | 1-12 | |
| A | EP 0 795 911 A (MITSUBISHI ELECTRIC CORP) 17 September 1997 (1997-09-17) * page 16, column 29, line 13 - line 25; figures 13,19 * | 1-12 | |
| A | EP 0 732 749 A (MITSUBISHI ELECTRIC CORP) 18 September 1996 (1996-09-18) * figure 13 * | 1-12 | **TECHNICAL FIELDS SEARCHED (Int.Cl.7)** H01L |
| A | TAKAHASHI H ET AL: "LOGIC DRIVE CONSIDERATION FOR TRENCH-GATE IGBT" IEEE INTERNATIONAL SYMPOSIUM ON POWER SEMICONDUCTOR DEVICES AND ICS,US,NEW YORK, NY: IEEE, vol. CONF. 9, 1997, pages 205-208, XP000800185 ISBN: 0-7803-3994-0 * page 205, column 1, paragraph II * | 1-12 | |
| A | US 5 468 982 A (VAN DER LINDE JAN ET AL) 21 November 1995 (1995-11-21) * figure 1 * | 1-12 | |

-/--

The present search report has been drawn up for all claims

| Place of search | Date of completion of the search | Examiner |
|---|---|---|
| BERLIN | 9 May 2000 | Juhl, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

20

EP 1 037 285 A1

| | European Patent Office | EUROPEAN SEARCH REPORT | Application Number EP 00 10 5310 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | US 5 821 580 A (KUWAHARA MASASHI) 13 October 1998 (1998-10-13) * figure 4 * | 1-12 | |

TECHNICAL FIELDS SEARCHED (Int.Cl.7)

The present search report has been drawn up for all claims

| Place of search | Date of completion of the search | Examiner |
|---|---|---|
| BERLIN | 9 May 2000 | Juhl, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

21

EP 1 037 285 A1

**ANNEX TO THE EUROPEAN SEARCH REPORT
ON EUROPEAN PATENT APPLICATION NO.**

EP 00 10 5310

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2000

| Patent document cited in search report | | Publication date | Patent family member(s) | | Publication date |
|---|---|---|---|---|---|
| EP 0668616 | A | 23-08-1995 | JP | 7235672 A | 05-09-1995 |
| EP 0795911 | A | 17-09-1997 | JP | 8316479 A | 29-11-1996 |
| | | | US | 6040599 A | 21-03-2000 |
| EP 0732749 | A | 18-09-1996 | JP | 8316479 A | 29-11-1996 |
| | | | US | 5751024 A | 12-05-1998 |
| | | | US | 6001678 A | 14-12-1999 |
| US 5468982 | A | 21-11-1995 | EP | 0712535 A | 22-05-1996 |
| | | | JP | 2893554 B | 24-05-1999 |
| | | | JP | 9500241 T | 07-01-1997 |
| | | | WO | 9534094 A | 14-12-1995 |
| US 5821580 | A | 13-10-1998 | JP | 9298298 A | 18-11-1997 |

EPO FORM P0459

For more details about this annex : see Official Journal of the European Patent Office, No. 12/82

22